# EUROPEAN PATENT SPECIFICATION

(11) **EP 4 647 788 B1**
(45) Date of publication and mention of the grant of the patent: **07.10.2026**
(21) Application number: 23925525.0
(22) Date of filing: 29.12.2023
(51) Int. Cl.: G01R 31/374, G01R 31/36, G01R 31/382, G01R 31/385, G01R 31/396, H02J 7/60, G01R 31/387, G01R 31/3828, G01R 31/367

(54) **DEVICE AND METHOD FOR CORRECTING BATTERY CHARGING OR DISCHARGING CAPACITY DATA**
VORRICHTUNG UND VERFAHREN ZUR KORREKTUR VON BATTERIELADE- ODER ENTLADEKAPAZITÄTSDATEN
DISPOSITIF ET PROCÉDÉ DE CORRECTION DE DONNÉES DE CAPACITÉ DE CHARGE OU DE DÉCHARGE DE BATTERIE

(30) Priority: 28.02.2023 KR 20230026796
(43) Date of publication of application: 12.11.2025
(73) Proprietor: LG Energy Solution, Ltd., Seoul 07335 (KR)
(72) Inventor: KANG, Ju Young, Daejeon 34122 (KR); PARK, Heung Il, Daejeon 34122 (KR); LEE, Da Jin, Daejeon 34122 (KR); CHO, In Hwan, Daejeon 34122 (KR); SEO, Jung Oh, Daejeon 34122 (KR)
(74) Representative: Plasseraud IP
(86) International application number: PCT/KR2023/022041
(87) International publication number: WO 2024/181661

(56) References cited:
- CN-A- 106 125 008
- CN-A- 107 290 684
- CN-A- 110 673 039
- JP-A- 2001 008 375
- JP-A- 2005 037 286
- KR-A- 20180 057 202
- KR-A- 20200 101 754
- KR-A- 20200 101 754
- US-A1- 2012 004 873

## Description

### TECHNICAL FIELD

The present invention relates to an apparatus and method for correcting data of charge and discharge capacity of a battery, and particularly to an apparatus and method for correcting data of charge and discharge capacity of a battery that can secure accurate data by correcting a data error in a charger and discharger test.

### BACKGROUND ART

A secondary battery capable of charging and discharging, that is, a battery, is widely used as an energy source for mobile devices such as smart phones. In addition, the battery is used as an energy source for eco-friendly vehicles such as an electric vehicle and a hybrid electric vehicle proposed as a solution to air pollution caused by a gasoline vehicle and a diesel vehicle using fossil fuels. The types of applications using the battery are becoming very diverse, and it is expected that the battery will be applied to more fields and products than now in the future.

Currently commercialized available batteries include a nickel cadmium battery, a nickel hydrogen battery, a nickel zinc battery, and a lithium ion battery. Among these batteries, the lithium ion battery is spotlighted due to their advantages of free charge and discharge, very low self-discharge rate, and high energy density because the memory effect hardly occurs compared to the nickel-based battery. In addition, since the lithium ion battery can be manufactured to be lightweight in a small size, the lithium ion battery is used as a power source for mobile devices, and the use range thereof has been expanded as a power source for the electric vehicle, thereby drawing attention as a next-generation energy storage medium.

However, as demand increases, batteries have increasingly higher energy densities and higher capacities. However, due to repeated charging and discharging, an amount of heat generated by the battery may increase, which may cause excessive temperature rise and resulting malfunction of the device. Ultimately, an operating efficiency of the battery may decrease and a lifespan of the battery may be significantly shortened.

In order to ensure an optimal operating state and safety of the battery, a plurality of tests are conducted during a battery production process. For example, in the process of producing the battery, the battery charge and discharge test can be performed using a charger and discharger. In the battery charge and discharge test, a battery cell may be charged and discharges using the charger and discharger and a charge capacity and discharge capacity may be measured, through which the characteristics of the battery may be checked. However, if a degree of precision of the charger and discharger decreases in the process of using the charger and discharger, a degree of accuracy of a charging voltage of the battery cell decreases, and as a result, an error occurs in charger and discharger test data, and thus the test result of the battery becomes unreliable. In addition, due to this error, it is not possible to determine whether the test result is due to the battery cell or the charger and discharger, and thus the test may be stopped for safety. Therefore, there are cases where testers re-test due to unavailability of data. The documents US 2012/004873, CN 106125008, KR 2020 0101754 and CN 107290684 are known, but fail to overcome the aforementioned issues.

Related prior art includes the following document.

Patent document 1: Korean registered patent No. 10-1456425

### DISCLOSURE OF THE INVENTION

### TECHNICAL PROBLEM

The present invention provides an apparatus and method for correcting data of charge and discharge capacity of a battery that can secure accurate data by correcting a data error of charger and discharger test.

The present invention provides an apparatus and method for correcting data of charge and discharge capacity of a battery that can secure accurate data by correcting the data error of charger and discharger test by applying a predetermined correction value depending on an average value of a difference between a charge capacity and discharge capacity of the battery.

### TECHNICAL SOLUTION

The object of the invention is achieved by the subject-matter of the independent claims. Advantageous embodiments are defined in the dependent claims. Further examples are provided for facilitating the understanding of the invention.

### ADVANTAGEOUS EFFECTS

The apparatus and method for correcting data of charge and discharge capacity of the battery according to the present invention calculates the charge capacity and discharge capacity of the battery, calculates the difference between the battery charge capacity and discharge capacity in each charge and discharge cycle to obtain data of charge and discharge capacity of the battery for a predetermined number of cycles, calculates the average value of the difference between the charge capacity and the discharge capacity for the predetermined number of cycles, and corrects the data by subtracting a predetermined correction value from the charge capacity value of each cycle when the average value of the difference between the charge capacity and the discharge capacity for the predetermined number of cycles is greater than or equal to a predetermined difference reference value. That is, the present invention corrects the data by subtracting the predetermined correction value from the charge capacity value of each cycle when the average value of the difference between the charge capacity and the discharge capacity for the predetermined number of cycles is greater than or equal to the reference value. Therefore, the present invention can correct the error in the charger and discharger test data error and thus improve battery test reliability.

### BRIEF DESCRIPTION OF THE DRAWINGS

FIG. 1 is a block diagram for describing an apparatus for correcting data of charge and discharge capacity of a battery according to an embodiment of the present invention.
FIG. 2 is a block diagram for describing a method for correcting data of charge and discharge capacity of a battery according to an embodiment of the present invention.
FIG. 3 is a graph illustrating a difference between a charge capacity and a discharge capacity for each charge and discharge cycle.
FIG. 4 is a graph illustrating an average value of the difference between the charge capacity and the discharge capacity of the battery and the results of applying correction depending on the average value.
FIG. 5 is raw data illustrating the charge capacity for each charge and discharge cycle and the charge capacity before and after correction.

### MODE FOR CARRYING OUT THE INVENTION

Hereinafter, embodiments of the present invention will be described in detail with reference to the accompanying drawings. However, the present invention is not limited to the embodiments disclosed below, but will be implemented in a variety of different forms, and these embodiments are provided only to complete the disclosure of the present invention and to fully inform those skilled in the art of the scope of the invention. In the drawing, the thickness is enlarged and expressed in order to clearly express various layers and each region, and in the drawing, the same reference sign refers to the same element.

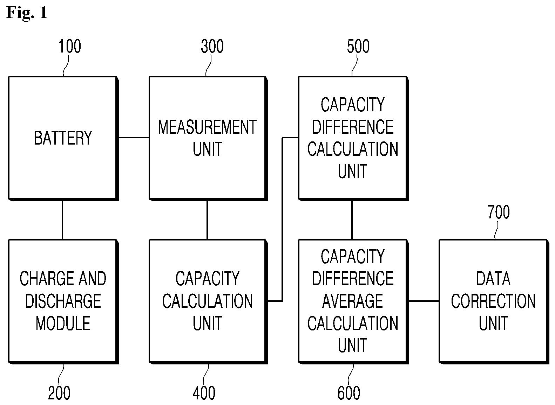

FIG. 1 is a block diagram for describing an apparatus for correcting data of charge and discharge capacity of a battery according to an embodiment of the present invention.

Referring to FIG. 1, the apparatus for correcting data of charge and discharge capacity of the battery according to an embodiment of the present invention may include a battery 100 including at least one battery cell capable of being charged and discharged, a charge and discharge module 200 for charging and discharging the battery 100, a measurement unit 300 that measures a state of the battery 100, such as a voltage and a current, a capacity calculation unit 400 that calculates a charge capacity and a discharge capacity of the battery 100 using the state of the battery 100, a capacity difference calculation unit 500 that calculates a difference between the battery charge capacity and discharge capacity in each charge and discharge cycle, a capacity difference average calculation unit 600 that calculates an average value of the difference between the charge capacity and the discharge capacity for a predetermined number of cycles, and a data correction unit 700 that subtracts a predetermined correction value from the charge capacity value of each cycle when the average value of the difference between the charge capacity and the discharge capacity for a predetermined number of cycles is greater than or equal to a predetermined difference reference value. The apparatus for correcting data of charge and discharge capacity of the battery according to an embodiment of the present invention will be described in more detail for each configuration as follows.

### 1. Battery

The battery 100 can be tested by seating the battery 100 on a predetermined seating portion (not illustrated). In this case, the battery 100 may include a battery cell as a target to be tested. At least one battery cell may be seated on the seating portion. That is, one or more battery cells may be seated on the seating portion and at least one battery cell may be tested. The battery cell may include an electrode assembly including a first electrode, a second electrode, and a separation film interposed between the electrodes, and a battery can that accommodates the electrode assembly. That is, the battery cell may be configured with an electrode assembly accommodated in a battery can. In this case, one of the first and second electrodes may be an anode, and the other may be a cathode. For example, the electrode assembly may include a positive electrode plate formed by applying a positive electrode active material to a positive electrode current collector, a negative electrode plate formed by applying a negative electrode active material to a negative electrode current collector, and a separation film interposed between the positive electrode plate and the negative electrode plate to prevent short circuit between the two electrode plates and enable the movement of lithium ions. In this case, one of the first and second electrodes may be the positive electrode plate and the other may be the negative electrode plate. The positive electrode plate may be the first electrode and the negative electrode plate may be the second electrode. The electrode assembly may have a jelly-roll structure, for example. That is, the electrode assembly may be manufactured by stacking sheet-shaped positive electrode and negative electrode plates at least once in a state where a separation film is interposed between the positive electrode and negative electrode plates to form a stacked body, and winding the stacked body around the center of the winding.

Meanwhile, the battery 100 of the present invention may include a battery module or a battery pack. That is, a plurality of battery cells may form a battery module, and two or more battery modules may form a battery pack, and the present invention may also test the battery module or the battery pack. When a plurality of battery cells form the battery module or the battery pack, the plurality of battery cells may be connected in series and/or in parallel in various ways. Meanwhile, the type of battery cell, which is a basic unit that makes up the battery 100, is not particularly limited, and may include, for example, a lithium ion battery, a lithium polymer battery, a nickel cadmium battery, a nickel hydrogen battery, or a nickel zinc battery.

### 2. Charge and discharge module

The charge and discharge module 200 may charge and discharge the battery 100. That is, in order to charge and discharge the battery 100 including at least one battery cell, the battery 100 may be charged or discharged using a predetermined charge and discharge module 200. The charge and discharge module 200 may perform a series of operations of charging the battery 100, maintaining the battery 100 for a predetermined time, discharging the battery 100, and maintaining the battery 100 for a predetermined time in this order. That is, the charge/discharge module 200 may perform a charge/discharge test of the battery 100 by charging/discharging the battery 100 for a plurality of cycles, with one cycle of charging, maintaining, discharging, and maintaining. Here, in order to charge the battery 100, a predetermined voltage may be applied to the battery 100 using the charge and discharge module 200, and in order to discharge the battery 100, a ground voltage may be applied to the battery 100 using, for example, the charge and discharge module 200. Charging, discharging, and maintenance thereof using the charge and discharge module 200 may be performed for a time set in the charge and discharge module 200. That is, the charge and discharge module 200 applies a predetermined current and voltage for a predetermined time in order to charge the battery 100, and cuts off the supply of power to the battery 100 for a predetermined time in order to maintain a charged state. In addition, the charge and discharge module 200 applies the ground voltage for a predetermined time in order to discharge the battery 100, and cuts off the supply of power to the battery 100 for a predetermined time in order to maintain a discharge state. In this way, the battery 100 may be charged, maintained in the charged state, discharged, and maintained in the discharged state by performing supplying and cut off of charging power and supplying and cutting off of discharging power for a predetermined time using the charge and discharge module 200.

### 3. Measurement unit

The measurement unit 300 may be provided to measure a state of the battery 100. That is, the measurement unit 300 may be connected to the battery 100 seated on the seating portion to measure the state of the battery 100. In this case, the measurement unit 200 may measure the state of the battery module and battery pack from at least one battery cell. That is, when one or more battery cells are seated on the seating portion, the measurement unit 300 may measure the state of each battery cell, and may measure the state of each battery module or battery pack even when at least one battery module or battery pack is seated. This measurement unit 300 may measure the voltage, the current, etc. of the battery 100. To this end, the measurement unit 300 may include a voltage sensor that measures the voltage and a current sensor that measures the current. That is, the battery 100 may be charged or discharged using a predetermined charge and discharge module 200 in order to test charge and discharge of the battery 100 including at least one battery cell, and the measurement unit 200 may measure the voltage and the current during charge of the battery 100 and the voltage and current during discharge thereof. In this case, at least one voltage sensor and at least one current sensor are provided to simultaneously or sequentially measure the state of at least one battery 100 seated on the seating portion.

### 4. Capacity calculation unit

The capacity calculation unit 400 may calculate a charge capacity and a discharge capacity of the battery 100 using the state of the battery 100. For example, the capacity calculation unit 400 may calculate the charge capacity and the discharge capacity of the battery 100 using the current and the voltage of the battery 100. In this case, the capacity calculation unit 400 may calculate the capacity of the battery 100 using various known technologies. For example, the capacity of the battery cell may be calculated based on an open-circuit voltage of the battery cell. In addition, the capacity of the battery cell may be calculated by calculating an amount of current used in a full charge-full discharge cycle. That is, the charge capacity may be calculated by calculating the amount of current applied to the battery 100 when charging the battery 100 by applying a charging voltage for a predetermined time thereto, and the discharge capacity may be calculated by calculating the amount of current discharged from the battery 100 when discharging the battery 100 by applying a discharge voltage for a predetermined time thereto. For example, the charge capacity when charged at 100 A for 1 hour is 100 Ah, and the discharge capacity when discharged at 100 A for 2 hours is 200 Ah. In this case, the capacity calculation unit 400 may calculate the charge capacity and the discharge capacity of the battery 100 every cycle. That is, the battery 100 is charged and discharged with one cycle of charging the battery 100, maintaining the battery 100 for a predetermined time, discharging the battery 100, and maintaining the predetermined time, and the charge capacity and discharge capacity of the corresponding cycle are calculated. This charge and discharge cycle may be performed a plurality of times. For example, when charging and discharging cycles are performed 100 times, the capacity calculation unit 300 may calculate the charge capacity and the discharge capacity every cycle to calculate the charge capacity and the discharge capacity for 100 cycles.

### 5. Capacity difference calculation unit

The capacity difference calculation unit 500 calculates a difference between the battery charge capacity and discharge capacity in each cycle. The capacity calculation unit 400 calculates the charge capacity and the discharge capacity of the battery for a plurality of cycles. The capacity difference calculation unit 500 receives the charge capacity and discharge capacity from the capacity calculation unit 400 and calculates the difference therebetween. That is, the capacity difference calculation unit 500 receives the charge capacity and the discharge capacity every cycle from the capacity calculation unit 400, calculates the difference between the charge capacity and the discharge capacity, and calculates the difference between the charge capacity and the discharge capacity of each cycle during a plurality of cycles. For example, when the charge and discharge cycle is performed 100 times, the capacity difference calculation unit 500 may receive the charge capacity and discharge capacity for 100 cycles from the capacity calculation unit 400 and calculate the difference between the charge capacity and discharge capacity of each cycle. That is, the capacity difference calculation unit 500 may calculate the difference between the charge capacity and the discharge capacity for 100 cycles.

### 6. Capacity difference average calculation unit

The capacity difference average calculation unit 600 calculates an average value of a difference between the charge capacity and the discharge capacity during a predetermined number of cycles. The capacity difference average calculation unit 600 receives the difference between the charge capacity and the discharge capacity from the capacity difference calculation unit 500, and calculates the average value of the difference between the charge capacity and the discharge capacity for a predetermined number of cycles. That is, the capacity difference average calculation unit 600 calculates the average value of the difference between the charge capacity and the discharge capacity for some of the charge and discharge cycles among the plurality of charge and discharge cycles. For example, when the charge and discharge cycle is performed 100 times, the capacity difference average calculation unit 600 may calculate the average value of the difference between the charge capacity and the discharge capacity for 25 charge and discharge cycles. Therefore, from the above example, the capacity difference average calculation unit 600 may calculate the average value of the difference between the charge capacity and the discharge capacity for 1 to 4 cycles among 100 charge and discharge cycles. Of course, the capacity difference average calculation unit 600 may calculate the average value of the charge and discharge capacity difference not only for 25 charge and discharge cycles but also for cycles fewer than the number of charge and discharge cycles.

### 7. Data correction unit

The data correction unit 700 may correct the data by subtracting a predetermined correction value from the charge capacity value of each cycle when the average value of the difference between the charge capacity and the discharge capacity for a predetermined number of cycles is greater than or equal to a predetermined reference value. To this end, the data correction unit 700 compares the difference between the charge capacity and the discharge capacity for the predetermined number of cycles received from the capacity difference average calculation unit 600 with the reference value. When the difference value as a result of the comparison is greater than or equal to the reference value, the data correction unit 700 may correct the data by subtracting a predetermined correction value from the charge capacity value of each cycle. Here, the reference value set in the data correction unit 700 may be 0.1 Ah to 0.5 Ah, and the correction value may be 0.5 Ah to 1.5 Ah. In an embodiment of the present invention, the reference value may be 0.2 Ah and the correction value may be 1.0 Ah. As a specific example, when the reference value is 0.2 Ah, the correction value is 1.0 Ah, and the average value of the difference between the difference between the charge capacity and the discharge capacity of the battery 100 calculated from the capacity difference average calculation unit 600 is 1.0239 Ah, since the average value of the difference is larger than the reference value, the data can be corrected by subtracting 1.0 Ah from the charge capacity for each cycle. Therefore, the corrected average value of the difference between the capacities may be 0.0239 Ah. As another example, if the reference value is 0.2 Ah and the average value of the difference between the charge capacity and discharge capacity of the battery 100 is 0.057 Ah, correction is not applied because the average value of the difference is less than or equal to the reference value.

Here, the reference value may be derived from the results obtained by performing charge and discharge test of the battery 100 a plurality of times, and the reference value may be derived from the deviation between the charge capacity and the discharge capacity of normal data. For example, if the deviation between the charge capacity and the discharge capacity of the battery 100 of the normal data is 0.1 Ah or less, a margin of 0.1 Ah may be added and the reference value may be set to 0.2 Ah. The correction value may also be derived from the results obtained by performing the charge and discharge tests of the battery 100 a plurality of times, and a value for converting abnormal data determined to be due to an error in the charger and discharger into normal data can be set as the correction value. Meanwhile, the smaller the reference value, the smaller the correction value may be. In other words, the larger the reference value, the larger the correction value may be. For example, when the reference value is 0.1 Ah, the correction value may be 0.5 Ah, and as the reference value increases, the correction value increases, and thus when the reference value is 0.5 Ah, the correction value may be 1.5 Ah. In this case, the smaller the reference value and correction value, the more precise data correction is possible. Of course, the reference value and correction value may be set differently depending on the capacity of the battery 100, etc. The smaller the capacity of the battery 100, the smaller the reference value and correction value may be, and the larger the capacity of the battery 100, the smaller the reference value and correction value may be. For example, the reference value and correction value may be larger when testing the battery module than when testing the battery cell, and the reference value and correction value may be larger when testing the battery pack than when testing the battery module.

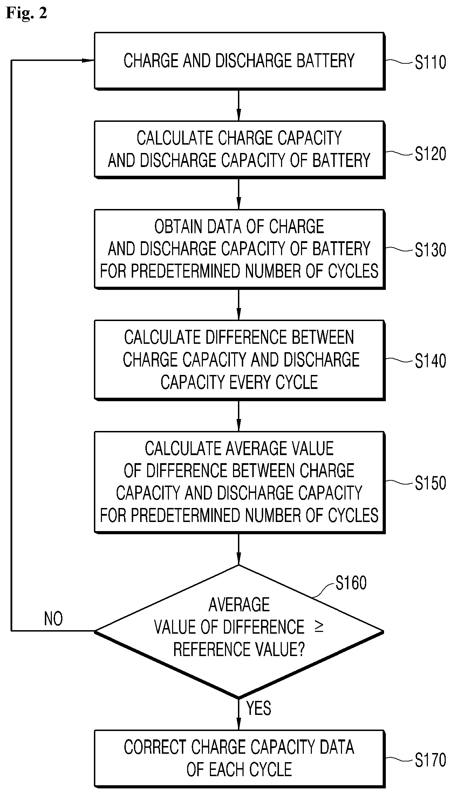

FIG. 2 is a flowchart for describing a method for correcting data of charge and discharge capacity of a battery according to an embodiment of the present invention. That is, FIG. 2 is a flowchart for describing a correction method using the apparatus for correcting data of charge and discharge capacity of the battery of FIG. 1.

Referring to FIG. 2, the method for correcting data of charge and discharge capacity of the battery according to an embodiment of the present invention may include a process of charging and discharging the battery S110, a process of calculating the charge capacity and the discharge capacity of the battery S120, a process of repeating the charge and discharge capacity measurement process for a predetermined number of cycles to obtain data of charge and discharge capacity of the battery for the predetermined number of cycles S130, a process of calculating the difference between the charge capacity and the discharge capacity every cycle S140, a process of calculating the average value of the difference between the charge capacity and the discharge capacity for a predetermined number of cycles S150, a process of comparing the calculated average value of the difference with a predetermined reference value S160, and a process of correcting charge capacity data of each cycle if the average value of the difference is greater than the reference value S170. The method for correcting data of charge and discharge capacity of the battery according to an embodiment of the present invention will be described in more detail for each process as follows.

S110: After seating the battery 100 on a predetermined seating portion, the battery 100 is charged and discharged using the charge and discharge module 200. In this case, the battery 100 may include a battery cell as a target to be tested. That is, one or more battery cells may be seated on the seating portion and at least one battery cell may be tested. Meanwhile, the battery 100 of the present invention may include the battery module or the battery pack. In addition, the battery 100 may be charged and discharged using the charge and discharge module 200. The charge and discharge module 200 may perform a series of operations of charging the battery 100, maintaining the battery 100 for a predetermined time, discharging the battery 100, and maintaining the battery 100 for a predetermined time in this order. That is, the charge/discharge module 200 may perform a charge/discharge test of the battery 100 by charging/discharging the battery 100 for a plurality of cycles, with one cycle of charging, maintaining, discharging, and maintaining.

S120: After measuring the state of the battery 100 using the measurement unit 300, the charge capacity and the discharge capacity of the battery 100 are calculated using the capacity calculation unit 400. The battery 100 is charged and discharged using the charge and discharge module 200, and the state of the battery 100 is measured using the measurement unit 300. That is, the measurement unit 200 may measure the voltage and the current during charge of the battery 100 and the voltage and current during discharge thereof. The capacity calculation unit 400 may calculate the charge capacity and the discharge capacity of the battery 100 using the state of the battery 100. For example, the capacity calculation unit 400 may calculate the charge capacity and the discharge capacity of the battery 100 using the current and the voltage of the battery 100. In this case, the capacity calculation unit 400 may calculate the capacity of the battery cell by, for example, calculating the amount of current used in a full charge-full discharge cycle. That is, the charge capacity may be calculated by calculating the amount of current applied to the battery 100 when charging the battery 100 by applying a charging voltage for a predetermined time thereto, and the discharge capacity may be calculated by calculating the amount of current discharged from the battery 100 when discharging the battery 100 by applying a discharge voltage for a predetermined time thereto. For example, the charge capacity when charged at 100 A for 1 hour is 100 Ah, and the discharge capacity when discharged at 100 A for 2 hours is 200 Ah.

S130: The data of charge and discharge capacity of the battery for a predetermined number of cycles is obtained. The capacity calculation unit 400 may calculate the charge capacity and the discharge capacity of the battery 100 every cycle. That is, the battery 100 is charged and discharged with one cycle of charging the battery 100, maintaining the battery 100 for a predetermined time, discharging the battery 100, and maintaining the predetermined time, and the charge capacity and discharge capacity of the corresponding cycle are calculated. This charge and discharge cycle may be performed a plurality of times. For example, when charging and discharging cycles are performed 100 times, the capacity calculation unit 300 may calculate the charge capacity and the discharge capacity for each cycle to calculate the charge capacity and the discharge capacity for 100 cycles.

S140: The difference between the charge capacity and the discharge capacity is calculated every cycle using the capacity difference calculation unit 500. The capacity calculation unit 400 calculates the charge capacity and the discharge capacity of the battery for a plurality of cycles. The capacity difference calculation unit 500 receives the charge capacity and discharge capacity from the capacity calculation unit 400 and calculates the difference therebetween. That is, the capacity difference calculation unit 500 receives the charge capacity and the discharge capacity every cycle from the capacity calculation unit 400, calculates the difference between the charge capacity and the discharge capacity, and calculates the difference between the charge capacity and the discharge capacity of each cycle for a plurality of cycles. For example, when the charge and discharge cycle is performed 100 times, the capacity difference calculation unit 500 may receive the charge capacity and discharge capacity for 100 cycles from the capacity calculation unit 400 and calculate the difference between the charge capacity and discharge capacity of each cycle. That is, the capacity difference calculation unit 500 may calculate the difference between the charge capacity and the discharge capacity for 100 cycles.

S150: The average value of the difference between the charge capacity and the discharge capacity during a predetermined number of cycles may be calculated using the average capacity difference calculation unit 600. The capacity difference average calculation unit 600 receives the difference between the charge capacity and the discharge capacity from the capacity difference calculation unit 500, and calculates the average value of the difference between the charge capacity and the discharge capacity during a predetermined number of cycles. That is, the capacity difference average calculation unit 600 calculates the average value of the difference between the charge capacity and the discharge capacity for some of the charge and discharge cycles among the plurality of charge and discharge cycles. For example, when the charge and discharge cycle is performed 100 times, the capacity difference average calculation unit 600 may calculate the average value of the difference between the charge capacity and the discharge capacity for 25 charge and discharge cycles. Therefore, from the above example, the capacity difference average calculation unit 600 may calculate the average value of the difference between the charge capacity and the discharge capacity for 1 to 4 cycles among 100 charge and discharge cycles. Of course, the capacity difference average calculation unit 600 may calculate the average value of the charge and discharge capacity difference not only for 25 charge and discharge cycles but also for cycles fewer than the number of charge and discharge cycles.

S160 and S170: The data correction unit 700 may compare the average value of the difference between the charge capacity and the discharge capacity during a predetermined number of cycles with a predetermined reference value, and correct the data by subtracting a predetermined correction value from the charge capacity value of each cycle when the average value of the difference is greater than or equal to the reference value. To this end, the data correction unit 700 compares the difference between the charge capacity and the discharge capacity for the predetermined number of cycles received from the capacity difference average calculation unit 600 with the reference value. When the difference value as a result of the comparison is greater than or equal to the reference value, the data correction unit 700 may correct the data by subtracting a predetermined correction value from the charge capacity value of each cycle. Here, the reference value set in the data correction unit 700 may be 0.1 Ah to 0.5 Ah, and the correction value may be 0.5 Ah to 1.5 Ah. In an embodiment of the present invention, the reference value may be 0.2 Ah and the correction value may be 1.0 Ah. As a specific example, when the reference value is 0.2 Ah, the correction value is 1.0 Ah, and the average value of the difference between the difference between the charge capacity and the discharge capacity of the battery 100 calculated from the capacity difference average calculation unit 600 is 1.0239 Ah, since the average value of the difference is larger than the reference value, the data can be corrected by subtracting 1.0 Ah from the charge capacity for each cycle. Therefore, the corrected average value of the difference between the capacities may be 0.0239 Ah. As another example, if the reference value is 0.2 Ah and the average value of the difference between the charge capacity and discharge capacity of the battery 100 is 0.057 Ah, correction is not applied because the average value of the difference is less than or equal to the reference value.

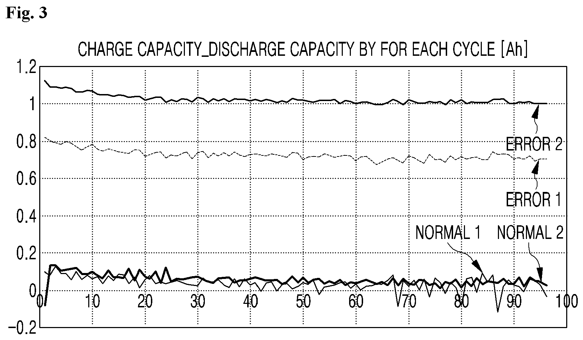

FIG. 3 is a graph illustrating the difference between the charge capacity and the discharge capacity for each charge and discharge cycle. As illustrated in FIG. 3, normal data lower than 0.2 Ah and error data higher than 0.2 Ah are illustrated. That is, FIG. 3 illustrates normal data with the difference between the charge capacity and the discharge capacity smaller than the reference value of 0.2 Ah and error data with the difference between the charge capacity and the discharge capacity larger than the reference value.

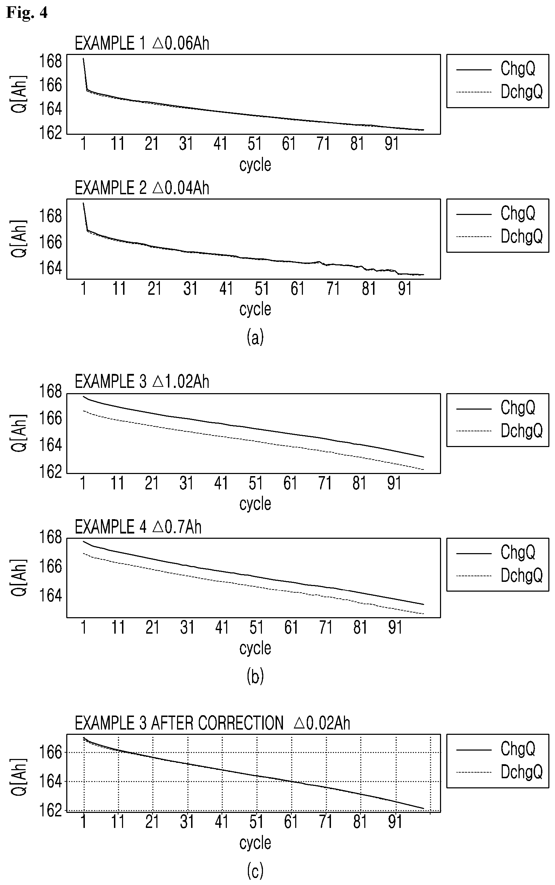

FIG. 4 is a graph illustrating the average value of the difference between the charge capacity and the discharge capacity of the battery and the results obtained by applying correction thereto according to the average value. That is, FIG. 4(a) is a graph when the average value of the difference between the charge capacity and the discharge capacity is smaller than the reference value, FIG. 4(b) is a graph when the average value of the difference between the charge capacity and the discharge capacity is larger than the reference value, and FIG. 4(c) is a graph after correction. Here, the reference value was set to 0.2 Ah and the correction value was set to 1.0 Ah. As illustrated in FIG. 4(a), in the case of Example 1, the average value of the difference between the charge capacity and the discharge capacity is 0.06 Ah, and in the case of Example 2, the average value of the difference between the charge capacity and the discharge capacity is 0.04 Ah. In the cases of Examples 1 and 2, the average value of the difference is smaller than the reference value of 0.2 Ah, and thus correction is not needed. However, as illustrated in FIG. 4(b), in the case of Example 3, the average value of the difference between the charge capacity and the discharge capacity is 1.02 Ah, and in the case of Example 4, the average value of the difference between the charge capacity and the discharge capacity is 0.7 Ah. In the cases of Examples 3 and 4, the average value of the difference is larger than the reference value of 0.2 Ah, and thus correction is needed. Therefore, as illustrated in FIG. 4(c), if the correction value of 1.0 Ah is subtracted from Example 3, the average value of the difference becomes 0.02 Ah.

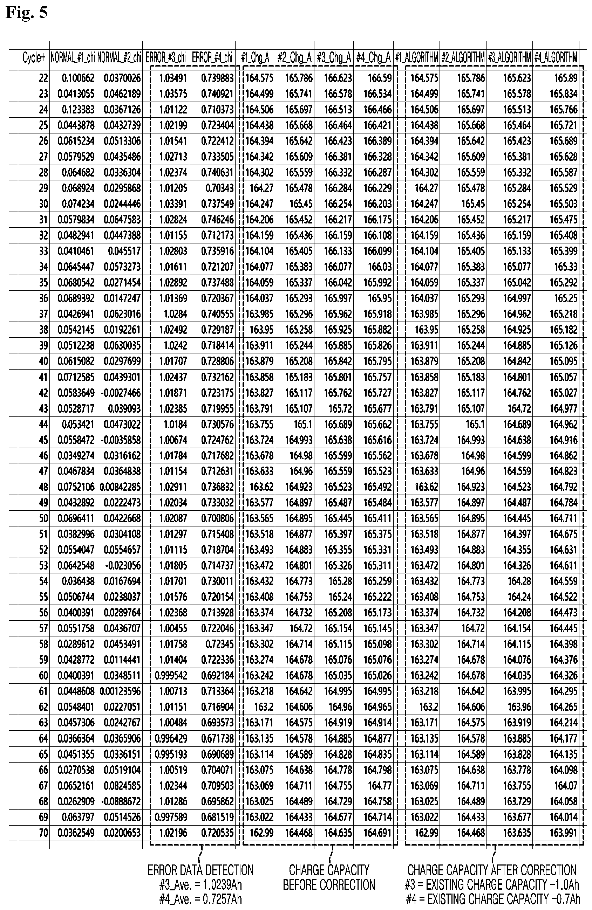

FIG. 5 is raw data illustrating the charge capacity for each charge and discharge cycle and the charge capacity before and after correction. As illustrated in FIG. 5, Normal_#1_chi and Normal_#2_chi are normal data in which the average value of the difference between the charge capacity and the discharge capacity is lower than the reference value 0.2 Ah, and ERROR_#3_chi and ERROR_#4_chi are error data in which the average value of the difference between the charge capacity and the discharge capacity is higher than the reference value. Here, #1, #2, #3, and #4 represent battery cells, respectively. That is, Normal_#1, Normal_#2, ERROR_#3, and ERROR_#4 represent normal battery cell 1, normal battery cell 2, faulty battery cell 3, and faulty battery cell 4, respectively. Meanwhile, the average value of the difference between the charge capacity and discharge capacity of ERROR_#3_chi is 1.0239 Ah, and the average value of the difference between the charge capacity and discharge capacity of ERROR_#4_chi is 0.7257 Ah. In addition, in FIG. 5, #1_Chg_A, #2_Chg_A, #3_Chg_A, and #4_Chg_A represent the charge capacity before correction, and #1_ALGORITHM, #2_ALGORITHM, #3_ALGORITHM, and #4_ALGORITHM represent the charge capacity after applying correction. Here, correction is not performed because #1_ALGORITHM and #2_ALGORITHM are normal data where the average value of the difference between the charge capacity and the discharge capacity is lower than the reference value, #3_ALGORITHM represents the charge capacity after applying a correction value of 1.0 Ah, and #4_ALGORITHM represents the charge capacity after applying a correction value of 0.7 Ah. For example, in the case of Cycle 22, the average values of the differences of Normal_#1_chi and Normal_#2_chi are 0.100662 and 0.0370026, respectively, and the average values of the differences of ERROR_#3_chi and ERROR_#4_chi are 1.03491 and 0.739883, respectively. In addition, the charge capacities before correction of Normal_#1_chi, Normal_#2_chi, ERROR_#3_chi, and ERROR_#4_chi are 164.575, 165.786, 166.623, and 166.59, respectively. Each of the average values of the differences of Normal_#1_chi and Normal_#2_chi is smaller than the reference value and thus correction is applied thereto, and if correction values of 1.0 Ah and 0.7 Ah are applied to the charge capacity values of ERROR_#3_chi and ERROR_#4_chi, respectively, the charge capacity after correction becomes 165.623 and 165.89, respectively, as in #3_ALGORITHM and #4_ALGORITHM.

As described above, the apparatus and method for correcting data of charge and discharge capacity of the battery according to the embodiments of the present invention calculates the charge capacity and discharge capacity of the battery using the capacity calculation unit 400, calculates the difference between the battery charge capacity and discharge capacity in each charge and discharge cycle using the capacity difference calculation unit 500 to obtain data of charge and discharge capacity of the battery for a predetermined number of cycles, calculates the average value of the difference between the charge capacity and the discharge capacity for the predetermined number of cycles using the capacity difference average calculation unit 600, and corrects the data by subtracting a predetermined correction value from the charge capacity value of each cycle using the data correction unit 700 when the average value of the difference between the charge capacity and the discharge capacity for the predetermined number of cycles is greater than or equal to a predetermined difference reference value. That is, the present invention corrects the data by subtracting a predetermined correction value from the charge capacity value of each cycle when the average value of the difference between the charge capacity and the discharge capacity for the predetermined number of cycles is greater than or equal to the reference value. Therefore, the present invention can correct the error in the charger and discharger test data and thus improve battery test reliability.

## Claims

1. An apparatus for correcting data of charge and discharge capacity of a battery, the apparatus comprising:
a battery (100) including at least one battery cell capable of being charged and discharged;
a capacity calculation unit (400) that is configured to calculate a charge capacity and a discharge capacity of the battery;
a capacity difference calculation unit (500) that is configured to calculate a difference between the charge capacity and the discharge capacity of the battery;
a capacity difference average calculation unit (600) that is configured to calculate an average value of the difference between the charge capacity and the discharge capacity; and
a data correction unit (700) that is configured to apply a predetermined correction value to a charge capacity value of each cycle when the average value of the difference between the charge capacity and the discharge capacity is greater than or equal to a predetermined difference reference value.

2. The apparatus of claim **1,** wherein
the battery includes a battery module or a battery pack.

3. The apparatus of claim **1,** further comprising:
a charge and discharge module (200) for charging and discharging the battery, and a measurement unit for measuring a voltage and a current of the battery.

4. The apparatus of claim 3, wherein
the charge and discharge module is configured to charge and discharge the battery for a plurality of cycles with one cycle of charging, maintenance, discharging, and maintenance.

5. The apparatus of claim 4, wherein
the capacity calculation unit is configured to calculate the charge capacity and the discharge capacity of the battery every cycle for a plurality of cycles.

6. The apparatus of claim 5, wherein
the capacity difference calculation unit is configured to receive the charge capacity and the discharge capacity every cycle from the capacity calculation unit to calculate the difference between the charge capacity and the discharge capacity, and is configured to calculate a difference between the charge capacity and discharge capacity of each cycle for a plurality of cycles.

7. The apparatus of claim 6, wherein
the capacity difference average calculation unit is configured to calculate an average value of the difference between the charge capacity and the discharge capacity of at least some charge and discharge cycles among a plurality of charge and discharge cycles.

8. The apparatus of claim 7, wherein
the reference value is 0.1 Ah to 0.5 Ah, and the correction value is 0.5 Ah to 1.5 Ah.

9. The apparatus of claim 8, wherein
the data correction unit is configured to subtract a predetermined correction value from the charge capacity value of each cycle when the average value of the difference is greater than or equal to the difference reference value.

10. A method for correcting data of charge and discharge capacity of a battery, the method comprising:
a process of charging and discharging a battery including at least one battery cell capable of being charged and discharged (S110);
a process of calculating a charge capacity and a discharge capacity of the battery (S120);
a process of obtaining data of charge and discharge capacity of the battery by repeating the process of calculating the charge capacity and the discharge capacity for a plurality of cycles (S130);
a process of calculating a difference between the charge capacity and discharge capacity for each cycle (S140);
a process of calculating an average value of the difference between the charge capacity and the discharge capacity for a predetermined number of cycles (S150); and
a process of comparing the average value of the difference with a predetermined reference value and correcting charge capacity data of each cycle if the average value of the difference is greater than or equal to the reference value (S160).

11. The method of claim 10, wherein
the battery includes a battery module or a battery pack.

12. The method of claim 10, wherein
the battery is charged and discharged for a plurality of cycles, with one cycle of charging, maintenance, discharging, and maintenance.

13. The method of claim 12, wherein
the charge capacity and the discharge capacity of the battery are calculated every cycle for a plurality of charging and discharging cycles.

14. The method of claim 13, wherein
the difference between the charge capacity and the discharge capacity is calculated for each cycle for a plurality of cycles.

15. The method of claim 14, wherein
the reference value is 0.1 Ah to 0.5 Ah, and the correction value is 0.5 Ah to 1.5 Ah.

## Patentansprüche

1. Einrichtung zum Korrigieren von Lade- und Entladekapazitätsdaten einer Batterie, wobei die Einrichtung umfasst:
eine Batterie (100), die mindestens eine Batteriezelle beinhaltet, die imstande ist, geladen und entladen zu werden;
eine Kapazitätsberechnungseinheit (400), die konfiguriert ist, um eine Ladekapazität und eine Entladekapazität der Batterie zu berechnen;
eine Kapazitätsdifferenz-Berechnungseinheit (500), die konfiguriert ist, um eine Differenz zwischen der Ladekapazität und der Entladekapazität der Batterie zu berechnen;
eine Berechnungseinheit für den Mittelwert der Kapazitätsdifferenz (600), die konfiguriert ist, um einen Mittelwert der Differenz zwischen der Ladekapazität und der Entladekapazität zu berechnen; und
eine Datenkorrektureinheit (700), die konfiguriert ist, um einen vorbestimmten Korrekturwert auf einen Ladekapazitätswert jedes Zyklus anzuwenden, wenn der Mittelwert der Differenz zwischen der Ladekapazität und der Entladekapazität größer oder gleich einem vorbestimmten Differenzreferenzwert ist.

2. Einrichtung nach Anspruch 1, wobei
die Batterie ein Batteriemodul oder einen Batteriepack beinhaltet.

3. Einrichtung nach Anspruch 1, weiter umfassend:
ein Lade- und Entlademodul (200) zum Laden und Entladen der Batterie, und
eine Messeinheit zum Messen einer Spannung und eines Stroms der Batterie.

4. Einrichtung nach Anspruch 3, wobei
das Lade- und Entlademodul konfiguriert ist, um die Batterie für eine Vielzahl von Zyklen mit einem Zyklus zum Laden, Warten, Entladen und Warten zu laden und zu entladen.

5. Einrichtung nach Anspruch 4, wobei
die Kapazitätsberechnungseinheit konfiguriert ist, um die Ladekapazität und die Entladekapazität der Batterie in jedem Zyklus für eine Vielzahl von Zyklen zu berechnen.

6. Einrichtung nach Anspruch 5, wobei
die Kapazitätsdifferenz-Berechnungseinheit konfiguriert ist, dass sie die Ladekapazität und die Entladekapazität in jedem Zyklus von der Kapazitätsberechnungseinheit zu empfangen, um die Differenz zwischen der Ladekapazität und der Entladekapazität zu berechnen, und konfiguriert ist, um eine Differenz zwischen der Ladekapazität und der Entladekapazität jedes Zyklus für eine Vielzahl von Zyklen zu berechnen.

7. Einrichtung nach Anspruch 6, wobei
die Berechnungseinheit für den Mittelwert der Kapazitätsdifferenz konfiguriert ist, um einen Mittelwert der Differenz zwischen der Ladekapazität und der Entladekapazität mindestens einiger Lade- und Entladezyklen aus einer Vielzahl von Lade- und Entladezyklen zu berechnen.

8. Einrichtung nach Anspruch 7, wobei
der Referenzwert 0,1 Ah bis 0,5 Ah beträgt, und der Korrekturwert 0,5 Ah bis 1,5 Ah beträgt.

9. Einrichtung nach Anspruch 8, wobei
die Datenkorrektureinheit konfiguriert ist, um einen vorbestimmten Korrekturwert vom Ladekapazitätswert jedes Zyklus zu subtrahieren, wenn der Mittelwert der Differenz größer oder gleich dem Differenzreferenzwert ist.

10. Verfahren zum Korrigieren von Lade- und Entladekapazitätsdaten einer Batterie, wobei das Verfahren umfasst:
einen Prozess zum Laden und Entladen einer Batterie, die mindestens eine Batteriezelle beinhaltet, die imstande ist, geladen und entladen zu werden (S110);
einen Prozess zum Berechnen einer Ladekapazität und einer Entladekapazität der Batterie (S120);
einen Prozess zum Erhalten von Daten der Lade- und Entladekapazität der Batterie durch Wiederholen des Prozesses zum Berechnen der Ladekapazität und der Entladekapazität für eine Vielzahl von Zyklen (S130);
einen Prozess zum Berechnen einer Differenz zwischen der Ladekapazität und der Entladekapazität für jeden Zyklus (S140);
einen Prozess zum Berechnen eines Mittelwerts der Differenz zwischen der Ladekapazität und der Entladekapazität für eine vorbestimmte Anzahl an Zyklen (S150); und
einen Prozess zum Vergleichen des Mittelwerts der Differenz mit einem vorbestimmten Referenzwert und Korrigieren von Ladekapazitätsdaten jedes Zyklus, wenn der Mittelwert der Differenz größer oder gleich dem Referenzwert ist (S160).

11. Verfahren nach Anspruch 10, wobei
die Batterie ein Batteriemodul oder einen Batteriepack beinhaltet.

12. Verfahren nach Anspruch 10, wobei
die Batterie für eine Vielzahl von Zyklen mit einem Zyklus zum Laden, Warten, Entladen und Warten geladen und entladen wird.

13. Verfahren nach Anspruch 12, wobei
die Ladekapazität und die Entladekapazität der Batterie in jedem Zyklus für eine Vielzahl von Lade- und Entladezyklen berechnet werden.

14. Verfahren nach Anspruch 13, wobei
die Differenz zwischen der Ladekapazität und der Entladekapazität für jeden Zyklus für eine Vielzahl von Zyklen berechnet wird.

15. Verfahren nach Anspruch 14, wobei
der Referenzwert 0,1 Ah bis 0,5 Ah beträgt und der Korrekturwert 0,5 Ah bis 1,5 Ah beträgt.

## Revendications

1. Appareil pour la correction de données de capacité de charge et de décharge d'une batterie, l'appareil comprenant :
une batterie (100) incluant au moins une cellule de batterie apte à être chargée et déchargée ;
une unité de calcul de capacité (400) qui est configurée pour calculer une capacité de charge et une capacité de décharge de la batterie ;
une unité de calcul de différence de capacité (500) qui est configurée pour calculer une différence entre la capacité de charge et la capacité de décharge de la batterie ;
une unité de calcul de moyenne de différence de capacité (600) qui est configurée pour calculer une valeur moyenne de la différence entre la capacité de charge et la capacité de décharge ; et
une unité de correction de données (700) qui est configurée pour appliquer une valeur de correction prédéterminée à une valeur de capacité de charge de chaque cycle lorsque la valeur moyenne de la différence entre la capacité de charge et la capacité de décharge est supérieure ou égale à une valeur de référence de différence prédéterminée.

2. L'appareil selon la revendication 1, dans lequel
la batterie inclut un module de batterie ou un bloc-batterie.

3. L'appareil selon la revendication 1, comprenant en outre :
un module de charge et de décharge (200) pour charger et décharger la batterie, et
une unité de mesure pour mesurer une tension et un courant de la batterie.

4. L'appareil selon la revendication 3, dans lequel
le module de charge et de décharge est configuré pour charger et décharger la batterie pendant une pluralité de cycles avec un cycle de charge, de maintenance, de décharge et de maintenance.

5. L'appareil selon la revendication 4, dans lequel
l'unité de calcul de capacité est configurée pour calculer la capacité de charge et la capacité de décharge de la batterie à chaque cycle pendant une pluralité de cycles.

6. L'appareil selon la revendication 5, dans lequel
l'unité de calcul de différence de capacité est configurée pour recevoir la capacité de charge et la capacité de décharge à chaque cycle de l'unité de calcul de capacité pour calculer la différence entre la capacité de charge et la capacité de décharge, et est configurée pour calculer une différence entre la capacité de charge et la capacité de décharge de chaque cycle pendant une pluralité de cycles.

7. L'appareil selon la revendication 6, dans lequel
l'unité de calcul de moyenne de différence de capacité est configurée pour calculer une valeur moyenne de la différence entre la capacité de charge et la capacité de décharge d'au moins certains cycles de charge et de décharge parmi une pluralité de cycles de charge et de décharge.

8. L'appareil selon la revendication 7, dans lequel
la valeur de référence est de 0,1 Ah à 0,5 Ah, et la valeur de correction est de 0,5 Ah à 1,5 Ah.

9. L'appareil selon la revendication 8, dans lequel
l'unité de correction de données est configurée pour soustraire une valeur de correction prédéterminée de la valeur de capacité de charge de chaque cycle lorsque la valeur moyenne de la différence est supérieure ou égale à la valeur de référence de différence.

10. Méthode de correction de données de capacité de charge et de décharge d'une batterie, le procédé comprenant :
un procédé de charge et de décharge d'une batterie incluant au moins une cellule de batterie apte à être chargée et déchargée (S110) ;
un procédé de calcul d'une capacité de charge et d'une capacité de décharge de la batterie (S120) ;
un procédé d'obtention de données de capacité de charge et de décharge de la batterie en répétant l'étape de calcul de la capacité de charge et de la capacité de décharge pendant une pluralité de cycles (S130) ;
un procédé de calcul d'une différence entre la capacité de charge et la capacité de décharge pour chaque cycle (S140) ;
un procédé de calcul d'une valeur moyenne de la différence entre la capacité de charge et la capacité de décharge pendant un nombre prédéterminé de cycles (S150) ; et
un procédé de comparaison de la valeur moyenne de la différence avec une valeur de référence prédéterminée et de correction des données de capacité de charge de chaque cycle si la valeur moyenne de la différence est supérieure ou égale à la valeur de référence (S160).

11. La méthode selon la revendication 10, dans laquelle
la batterie inclut un module de batterie ou un bloc-batterie.

12. La méthode selon la revendication 10, dans laquelle
la batterie est chargée et déchargée pendant une pluralité de cycles, avec un cycle de charge, de maintenance, de décharge et de maintenance.

13. La méthode selon la revendication 12, dans laquelle
la capacité de charge et la capacité de décharge de la batterie sont calculées à chaque cycle pendant une pluralité de cycles de charge et de décharge.

14. La méthode selon la revendication 13, dans laquelle
la différence entre la capacité de charge et la capacité de décharge est calculée pour chaque cycle pendant une pluralité de cycles.

15. La méthode selon la revendication 14, dans laquelle
la valeur de référence est de 0,1 Ah à 0,5 Ah, et la valeur de correction est de 0,5 Ah à 1,5 Ah.
